# EUROPEAN PATENT SPECIFICATION

(11) **EP 2 674 967 B1**
(45) Date of publication and mention of the grant of the patent: **10.01.2018**
(21) Application number: 11858400.2
(22) Date of filing: 16.11.2011
(51) Int. Cl.: H01L 21/268, H01L 21/265, H01L 21/337

(54) **LASER ANNEALING METHOD AND LASER ANNEALING APPARATUS**
LASERGLÜHVERFAHREN UND LASERGLÜHVORRICHTUNG
PROCÉDÉ DE RECUIT AU LASER ET APPAREIL DE RECUIT AU LASER

(30) Priority: 09.02.2011 JP 2011025980
(43) Date of publication of application: 18.12.2013
(73) Proprietor: Sumitomo Heavy Industries, Ltd., Tokyo 141-6025 (JP)
(72) Inventor: SAKURAGI, Susumu, Yokosuka-shi Kanagawa 237-0061 (JP)
(74) Representative: Emde, Eric
(86) International application number: PCT/JP2011/006382
(87) International publication number: WO 2012/107979

(56) References cited:
- JP-A- 7 029 845
- JP-A- 2004 039 984
- JP-A- 2005 136 218
- JP-A- 2007 123 300
- JP-A- 2007 123 300
- JP-A- 2009 032 858
- JP-A- 2009 267 095
- JP-A- 2010 283 325
- US-A1- 2009 227 121
- US-A1- 2012 234 810
- Toshio Joshua Kudo ET AL: "PN Junction Formation for High-Performance Insulated Gate Bipolar Transistors (IGBT); Double-Pulsed Green Laser Annealing Technique", MRS Online Proceedings Library, 1 January 2006 (2006-01-01), XP055260403, DOI: 10.1557/PROC-0912-C03-11 Retrieved from the Internet: URL:http://journals.cambridge.org/action/d isplayFulltext?type=1&fid=7994430&jid=OPL& volumeId=912&issueId=-1&aid=7994428&bodyId =&membershipNumber=&societyETOCSession= [retrieved on 2016-03-22]

## Description

### Technical Field

The present invention relates to a laser annealing method and a laser annealing apparatus which activates dopants added to a semiconductor substrate by irradiation of a laser beam.

### Background Art

An invention related to a semiconductor device in which dopants are introduced into a semiconductor substrate by ion implantation, the introduced dopants are activated by irradiation of a laser beam, and an electrode layer and a field stop layer are formed and a method of manufacturing the semiconductor device is disclosed (refer to JP 2010-171057 A, for example). In the technique described in JP 2010-171057 A, after a surface structure of a semiconductor element is fabricated, a substrate is thinned. Thereafter, ion implantation is performed on a rear surface and irradiation of a pulsed laser beam is performed. The irradiation of the pulsed laser beam is performed in such a manner that a plurality of laser pulses are applied with a time difference of less than or equal to 600 ns. In detail, from the rear surface side of a silicon substrate, for example, phosphorus ions are ion-implanted into a field stop layer formation planned area in an n⁻ type substrate at a dose amount of less than or equal to 1E+14/cm² such that the field stop layer has peak concentration of less than or equal to 5E+18/cm³. Subsequently, for example, boron ions and phosphorus ions are respectively ion-implanted into a p⁺ type collector layer formation planned area and an n⁺ type cathode layer formation planned area from the rear surface side of the n⁻ type substrate at a dose amount of less than or equal to 5E+16/cm² such that a p⁺ type collector layer and an n⁺ type cathode layer have peak concentration of less than or equal to 1E+21/cm³.

It is known that the n⁺ type cathode layer or the like in which ions are implanted at such high concentration is amorphized due to breaking of the crystallinity of the silicon substrate. In the method of manufacturing a semiconductor device described in JP 2010-171057 A, since due to the irradiation of a laser beam, the dopants implanted into a deep portion of a depth exceeding 1 µm from a laser irradiated surface (the rear surface of the substrate) are subjected to defect recovery and activation by solid phase diffusion, sufficient temperature rise and heating time cannot be secured, and thus there is a case where activation becomes insufficient. If the energy density of the laser beam to be irradiated is increased in order to sufficiently perform the activation of the deep portion, a molten depth becomes deep, and thus the depth profile of the implanted dopants changes, whereby defects occurs such as characteristics as designed being unable to be obtained or the roughness of the substrate surface becoming worse.

A technique of performing laser annealing by irradiation of a pulsed laser beam at energy density in the range in which a silicon wafer does not melt is disclosed (refer to JP 2009-032858 A, for example). In this method, dopants are ion-implanted at high concentration, and thus it is not possible to completely recover the crystallinity of an amorphized area and activate the implanted dopants.

Toshio Joshua Kudo ET AL, "PN Junction Formation for High-Performance Insulated Gate Bipolar Transistors (IGBT); Double-Pulsed Green Laser Annealing Technique", MRS Online Proceedings Library, doi:10.1557/PROC-0912-C03-11, URL: http://journals.cambridge.org/action/displayFulltext? type=1&fid=7994430&jid=OPL&volumeId=912&issueId=-1&aid=7994 428&bodyId=&membershipNumber=&societyETOCSession=, MRS Proceedings, Volume 912, January 2006, 0912-C03-11, Published online: 01 February 2011, discloses that in order to form the deep PN junction demanded for the next generation IGBTs, the double-pulsed laser annealing technique as the low-thermal budget heat treatment has been introduced to activate a B-implant layer and a P-implant layer within the wafer surface to the depth 2µm. The double-pulsed laser annealing is characterized by the deep penetration depth due to a green wavelength of DPSS lasers and precisely and widely controlling of the annealing temperature and time. In the IGBT's structure the deep PN junction at a collector (the rear face) should be formed without damaging thermally circuit elements made of low melting point materials at a gate and an emitter (the front face) . Ion-implant samples using eight-inch (100) Si wafers were prepared as follows: Boron (B) implant was performed at a dose of 1E+15/cm² at an energy of 40keV and/or phosphorus (P) implant at 1E+13/cm² at an energy of 400keV. The double-pulsed laser irradiation was carried out at the constant first and second pulse energy density E1=E2=1. 8J/cm² at the delay time td= 0-500ns and the overlap ratio OR=67-90%. The melt depth was up to about 0.3µm. The electrical activation ratio of the B-implant layer within the depth of about 0.6µm was improved from 91% to about 100% with the delay time increase of 0ns to 500ns. The activation ratio of the P-implant layer within the depth of about 2µm was drastically improved from 48% to 82% with the same delay time increase and the carriers in the P-implant layer were distributed deeply from the depth 1.1µm to 1.8µm. Furthermore, with the overlap ratio increase of 67% to 90% the carriers in the P-implant layer were distributed deeply from the depth 1.8µm to 1.9µm and the high activation ratio of 82% was maintained. The high ratio of electrical activation is supported by the defect-free epitaxial regrowth where the majority of the B dopants was diffused in the liquid phase and that of the P dopants in the solid phase.

JP 2009-267095 A discloses a method of activating a semiconductor. When activating from a semiconductor surface layer into which an impurity is implanted to an internal layer, laser beams are irradiated at an energy density which does not fuse the surface layer to activate the surface layer side. Thereafter, the laser beams are irradiated at the higher energy density which does not fuse the surface layer to activate the internal layer side. The surface layer is crystallized by a first irradiation of the laser beams to raise a transmittance of the laser beams. It is possible to activate down to a deeper internal layer effectively without fusing the surface layer or forming an irregularity on the surface, and further it is possible to activate the surface layer side and the internal layer side by only changing the energy density, and to process by a single laser irradiator.

JP 2005-136218 A discloses a method for activating impurities, by which the impurities existing at a deep position from the substrate surface of a semiconductor substrate, having the impurities added to its surface layer, is activated. The method comprises a process of (a) irradiating the surface of the semiconductor substrate having the impurities added to its surface layer with a first pulse laser beam, and a process of (b) starting irradiating the surface of the semiconductor substrate with a second laser beam, during irradiation with the first laser beam in the process (a), or starting irradiating the surface of the semiconductor substrate with the second laser beam within 300 ns, from the time of finishing the irradiation with the first laser beam in the process (a).

JP 2007-123300 A discloses that in order to heat a position deep from the backside of a semiconductor substrate up to ≥950 °C while sustaining the intensity of pulse laser per unit area at a level not causing ablation in laser anneal, a method for activating impurities introduced into a semiconductor substrate comprises a step for forming a semiconductor region by introducing impurities from the surface of the semiconductor substrate, and a step for irradiating a local region on the surface of the semiconductor substrate with a plurality of pulse lasers using a plurality of laser oscillators . In the irradiation step, a difference is formed between a timing for irradiating the local region with the first pulse laser oscillated by the first laser oscillator and a timing for irradiating the local region with the second pulse laser oscillated by the second laser oscillator. The difference is regulated to ≤700 nanoseconds.

### Summary of Invention

### Problems to be Solved by the Invention

An object of the present invention is to provide a laser annealing method and a laser annealing apparatus in which high-quality annealing can be realized.

### Means of Solving the problems

According to an aspect of the invention, there is provided a laser annealing method as set forth in claim 1.

Further, according to another aspect of the invention, there is provided a laser annealing apparatus as set forth in claim 3.

In addition, the area with dopants added thereto at relatively high concentration is sometimes amorphized.

### Advantageous Effects of Invention

According to the invention, it is possible to provide a laser annealing method and a laser annealing apparatus in which high-quality annealing can be realized.

### Brief Description of Drawings

Fig. 1 is a schematic diagram showing a laser annealing apparatus according to an example.
Fig. 2 is a graph showing an example of a dopant depth profile of a silicon wafer 50.
Fig. 3 is a graph showing the relationship between the maximum arrival temperatures and the pulsed width of the pulse laser beam 20a, the maximum arrival temperatures correspond to temperatures of the position of a depth of 3 µm and the position of a depth of 100 µm (a front-side surface) from the back-side surface of the silicon wafer 50 when a pulse laser beam 20a has been irradiated under the condition that the back-side surface (a laser irradiated surface) of the silicon wafer 50 reaches a melting point (about 1690K).
Fig. 4 is a graph showing the results of the annealing performed by irradiating a silicon wafer with phosphorus (P) ion-implanted therein with energy of 2 MeV and at a dose amount of 3E+13/cm² with the pulsed laser beam 20a with a pulse width set as 20 µs and power density on an irradiated surface set as 420 kW/cm².
Fig. 5 is a graph showing energy density required to obtain a molten depth of 0.3 µm by irradiating a silicon wafer with a pulsed laser beam 10a that is a second harmonic of a Nd:YAG laser.
Fig. 6 is a cross-sectional TEM image of a silicon wafer with phosphorus (P) as dopants ion-implanted therein with energy of 100 keV and at a dose amount of 2E+15/cm².
Fig. 7 is a cross-sectional TEM image of the silicon wafer after annealing is performed by irradiating laser pulses having a relatively short pulse width to the silicon wafer shown in Fig. 6.
Fig. 8 is a cross-sectional TEM image of the silicon wafer after annealing is performed by irradiating laser pulses having a relatively long pulse width to the silicon wafer shown in Fig. 6.
Figs. 9A to 9C are graphs describing a laser annealing method according to a first example.
Figs. 10A to 10C are graphs describing a laser annealing method according to a second example.
Figs. 11A to 11C are graphs describing a laser annealing method according to a third example.

### Description of Embodiments

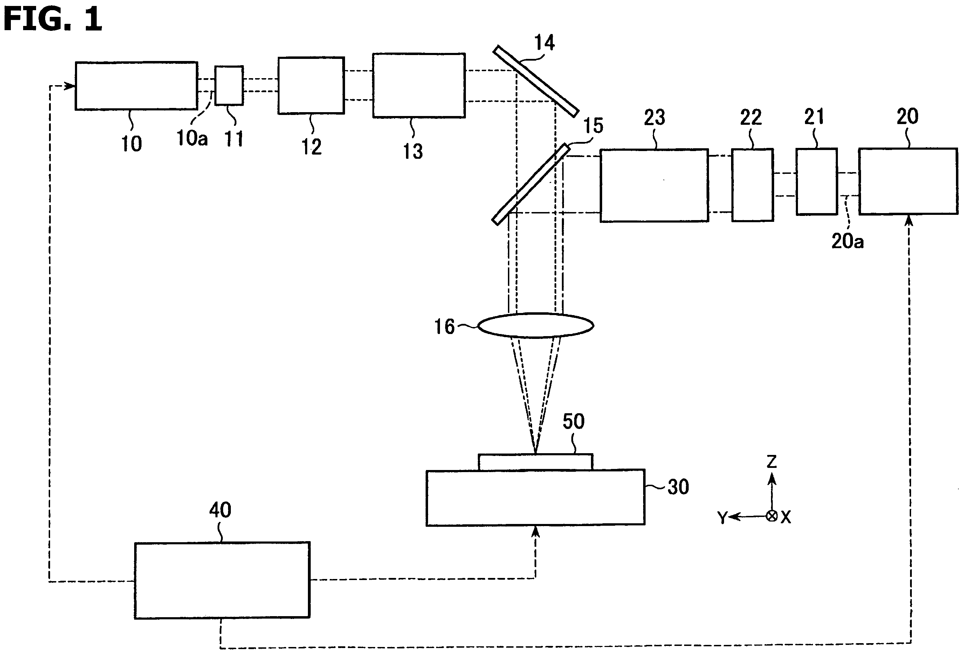

Fig. 1 is a schematic diagram showing a laser annealing apparatus according to an example. The laser annealing apparatus according to the example is configured to include laser light sources 10 and 20, attenuators 11 and 21, telescopes 12 and 22, homogenizers 13 and 23, a reflection mirror 14, a dichroic mirror 15, an imaging lens 16, a stage 30, and a control device 40.

The laser light source 10 includes a solid-state laser, for example, a Nd:YAG laser or a Nd:YLF laser, and a non-linear optical crystal and emits a pulsed laser beam 10a that is a second harmonic (wavelength: 532 nm) of the Nd:YAG laser or a second harmonic (wavelength: 527 nm) of the Nd:YLF laser in response to a trigger signal from the control device 40. The pulsed laser beam 10a is attenuated in light intensity by the attenuator 11 which attenuates the light intensity of an incident laser beam at a variable attenuation rate and then emits the laser beam, and is incident on the homogenizer 13 through the telescope 12. The homogenizer 13 divides the incident laser beam and overlaps the divided laser beams, thereby shaping the shape of the pulsed laser beam 10a on a worked surface (a laser irradiated surface) into, for example, a rectangular shape and also uniformizing light intensity in a plane.

The laser beam 10a emitted from the homogenizer 13 is reflected by the reflection mirror 14, penetrates the dichroic mirror 15, is condensed by the imaging lens 16, and is incident on a silicon wafer 50 retained on the stage 30 that is, for example, an XY stage so as to be movable in a two-dimensional direction (an X-axis direction and a Y-axis direction).

The laser light source 20 includes, for example, a semiconductor laser (laser diode; LD) and emits a pulsed laser beam 20a having a wavelength of, for example, 915 nm in response to the supply of pulsed power (electric current) from the control device 40. The pulsed laser beam 20a is attenuated in light intensity at a variable attenuation rate by the attenuator 21 and is incident on the homogenizer 23 through the telescope 22. The homogenizer 23 shapes the shape of the pulsed laser beam 20a on the worked surface into, for example, a rectangular shape and also uniformizes light intensity in a plane.

The laser beam 20a emitted from the homogenizer 23 is reflected by the dichroic mirror 15, is then condensed by the imaging lens 16, and is incident on the silicon wafer 50 retained on the stage 30.

The dichroic mirror 15 is a beam overlapper that overlaps the pulsed laser beams 10a and 20a on the same optical axis. Both the pulsed laser beams 10a and 20a form a rectangular incidence area having, for example, a length in a long axis direction (the X-axis direction) of 4 mm and a length in a short axis direction (the Y-axis direction) of 0.25 mm and are incident on the same area on the silicon wafer 50.

The control device 40 controls the emission of the pulsed laser beam 10a from the solid-state laser 10 and the emission of the pulsed laser beam 20a from the semiconductor laser 20. Further, the control device 40 controls an operation of the stage 30, thereby controlling the incident positions of the pulsed laser beams 10a and 20a on the silicon wafer 50 retained on the stage 30.

The pulse width of the pulsed laser beam 10a is relatively short and the pulse width of the pulsed laser beam 20a is relatively long. The pulse width of the pulsed laser beam 20a is, for example, greater than or equal to 20 times the pulse width of the pulsed laser beam 10a. The pulse width of, for example, the pulsed laser beam 20a can be controlled by the supply time of the pulsed power from the control device 40 to the

### semiconductor laser 20.

The silicon wafer 50 is a semiconductor substrate with dopants added thereto. Dopants are ion-implanted into a relatively deep area, for example, an area whose depth exceeds 1 µm, at relatively low concentration from a laser irradiated surface of the silicon wafer 50. Further, dopants are ion-implanted into a relatively shallow area, for example, an area whose depth is less than or equal to 1 µm, at relatively high concentration. In a case where the dopants added at high concentration are phosphorus (P), in an area with phosphorus (P) added thereto at high concentration, for example, silicon is amorphized.

The silicon wafer 50 is used for the production of, for example, an insulated gate bipolar transistor (IGBT). The thickness of the silicon wafer 50 is, for example, 100 µm. An emitter region and a gate region of the IGBT are defined in a surface layer portion on the front side of the silicon wafer 50. Further, a collector region by implantation of p type dopants, for example, boron (B) and a field stop region by implantation of n type dopants, for example, phosphorus (P) are defined in a surface layer portion on the back side.

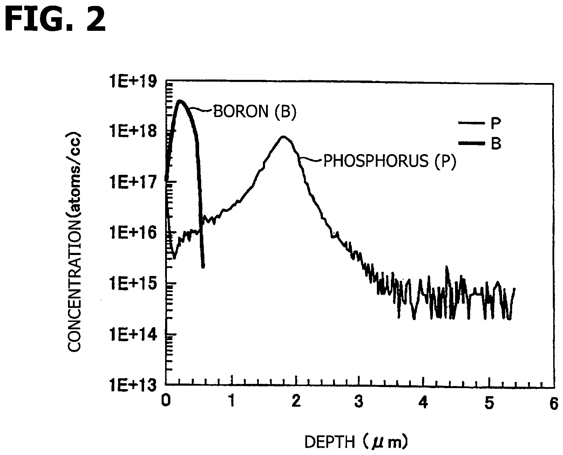

In Fig. 2, an example of a dopant depth profile of the silicon wafer 50 is shown. The horizontal axis of the graph represents the depth from the back-side surface of the silicon wafer 50 in a unit of "µm'' by a linear scale. The vertical axis of the graph represents the concentration of added dopants in a unit of "atoms/cc" by a logarithmic scale.

A depth of a position where the concentration of boron (B) reaches a peak is 0.3 µm from the back-side surface. Further, a depth of a position where the concentration of phosphorus (P) reaches a peak is 1.8 µm from the back-side surface . In addition, a tail of an implantation depth of phosphorus (P) extends to 3 µm from the back-side surface.

The back-side surface of the silicon wafer 50 is irradiated with the pulsed laser beams 10a and 20a. Activation annealing of the dopants (B) implanted into the collector region (an area that is relatively shallow from the laser irradiated surface) and the dopants (P) implanted into the field stop region (an area that is relatively deep from the laser irradiated surface) is performed by the irradiation of the pulsed laser beams 10a and 20a. In the silicon wafer 50 that is used for the production of the IGBT, it is not preferable that a front-side surface layer portion be subjected to high temperature during annealing.

By moving the silicon wafer 50 in the short axis direction (the Y-axis direction) of a rectangular beam incidence area on the surface of the silicon wafer 50, it is possible to anneal a strip-shaped area having a width that is equal to the length of the long axis direction (the X-axis direction) of the beam incidence area. When the beam incidence area of the pulsed laser beams 10a and 20a have moved to an end portion of the silicon wafer 50, the silicon wafer 50 is shifted in the long axis direction (the X-axis direction) of the beam incidence area. Thereafter, by moving the beam incidence area in the Y-axis direction on the silicon wafer 50 and repeating the treatment of annealing the strip-shaped area, it is possible to anneal the entire back-side surface of the silicon wafer 50. In the annealing, the pulsed laser beams 10a and 20a are incident upon the silicon wafer 50 at an overlap ratio of greater than or equal to 50%, for example.

The dopants (P) added to the relatively deep area, for example, the area whose depth exceeds 1 µm, at relatively low concentration are subjected to activation (non-melting annealing) by the pulsed laser beam 20a having a relatively long pulse width. The dopants (B) added to the relatively shallow area, for example, the area whose depth is less than or equal to 1 µm, at relatively high concentration are subjected to activation (melting annealing) by the pulsed laser beam 10a having a relatively short pulse width. The pulsed laser beam 10a is incident upon the silicon wafer 50 at energy density that melts a portion of the silicon from the surface to the position that is deeper than the area with the ion implantation of dopants performed at high concentration. By the irradiation of the pulsed laser beam 10a, a portion of the silicon wafer 50 which is irradiated with the pulsed laser beam 10a is melted. In the area with dopants (B) implanted at high concentration, liquid phase epitaxial growth arises and crystal defects are recovered. During the crystal defects are recovered, dopants (B) are sufficiently activated.

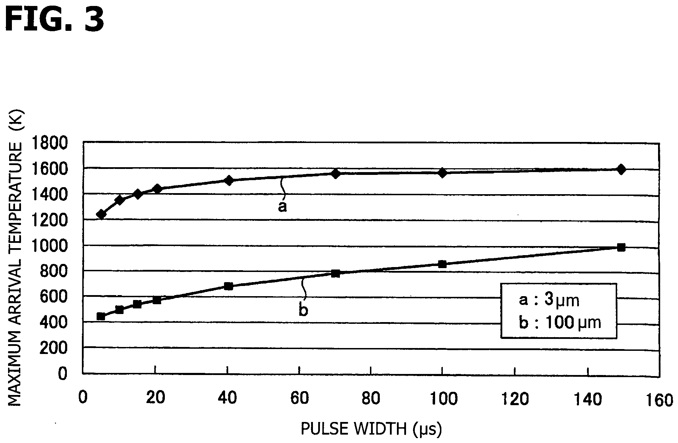

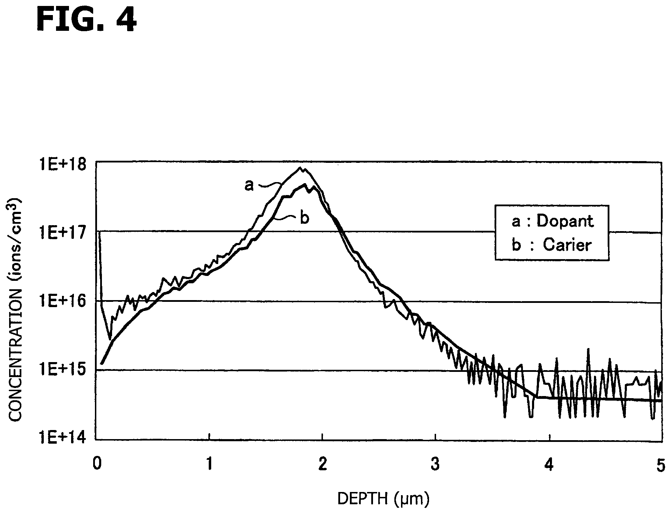

The activation of the dopants added to the relatively deep area at relatively low concentration by the irradiation of the pulsed laser beam 20a will be described referring to Figs. 3 and 4.

Fig. 3 is a graph showing the relationship between the maximum arrival temperatures and the pulse width of the pulsed laser beam 20a, the maximum arrival temperatures being temperatures of the position of a depth of 3 µm and the position of a depth of 100 µm (the front-side surface) from the back-side surface of the silicon wafer 50 (the laser irradiated surface) when the pulsed laser beam 20a has been incident under the condition that the back-side surface of the silicon wafer 50 reaches a melting point (about 1690K). The horizontal axis of the graph represents the pulse width of the pulsed laser beam 20a in a unit of "µs", and the vertical axis represents the maximum arrival temperature of the positions of the depth of 3 µm and the depth of 100 µm in a unit of "K". A curve a shows the relationship between the pulse width of the pulsed laser beam 20a and the maximum arrival temperature of the position of the depth of 3 µm, and a curve b shows the relationship between the pulse width of the pulsed laser beam 20a and the maximum arrival temperature of the position of the depth of 100 µm.

Referring to the curve a, in a case where the pulse width is less than 5 µs, a rise in the temperature of the depth of 3 µm is insufficient. For this reason, the pulse width of less than 5 µs is not preferable because the dopants added to a depth exceeding 3 µm are not activated sufficiently. Referring to the curve b, the longer the pulse width of the pulsed laser beam 20a, the more the temperature of the deep area rises, and thus it is advantageous to activate the dopants. However, it is not preferable in terms of a rise in the temperature of the front-side surface (the laser non-irradiated surface) of the silicon wafer 50, and the pulse width exceeding, for example, 100 µs will be undesirable. For this reason, it is preferable that the pulse width of the pulsed laser beam 20a having a wavelength of 915 nm, which is emitted from the semiconductor laser 20, be in a range of 5 µs to 100 µs. From the curves a and b, it will be more preferable to set the pulse width less than or equal to 40 µs in which a rise in the temperature of the depth of 3 µm is sufficient and a rise in the temperature of the depth of 100 µm is not remarkable.

In the example, as the laser light source 20, a semiconductor laser having a wavelength of 915 nm in which high output can be obtained at low cost is used. In addition, a semiconductor laser and other lasers, for example, may be used which outputs a laser beam having a wavelength of less than or equal to 950 nm in which a penetration length to silicon is about 30 µm at normal temperature.

Fig. 4 is a graph showing the results of the annealing performed by irradiating a silicon wafer with the pulsed laser beam 20a, the silicon wafer being ion-implanted with phosphorus (P) with energy of 2 MeV and at a dose amount of 3E+13/cm², the pulsed laser beam 20a having a pulse width of 20 µs and power density of 420 kW/cm² on an irradiated surface. The horizontal axis of the graph represents a depth from the laser irradiated surface in a unit of "µm" by a linear scale. The vertical axis of the graph represents the concentration of dopants and carriers in a unit of, for example, "ions/cm³" by a logarithmic scale. A curve a shows the depth profile of the dopants and a curve b shows the depth profile of the carriers.

It can be seen that about 70% of phosphorus (P) added to the relatively deep area at relatively low concentration can be activated by the irradiation of the pulsed laser beam 20a in the above-described conditions.

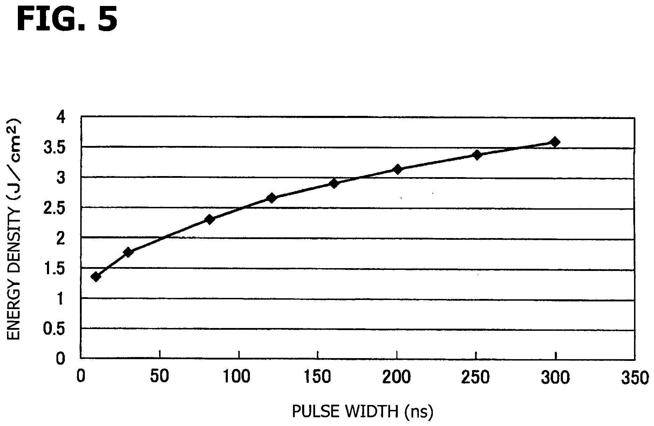

The activation of the dopants added to the relatively shallow area at relatively high concentration by the irradiation of the pulsed laser beam 10a will be described referring to Figs. 5 to 8.

The pulse width of the pulsed laser beam 10a is in a range of 30 ns to 250 ns, for example. In the example, as the pulsed laser beam 10a having a relatively short pulse width, the second harmonic of the Nd: YAG laser or the Nd:YLF laser is used. However, it is possible to preferably use a fundamental wave of the Nd:YAG laser or the Nd:YLF laser, or a fundamental wave or a second harmonic of a Q-switched solid-state laser other than that. In addition, a laser light source capable of emitting a laser pulse at a pulse width in a range of 30 ns to 250 ns, such as a CO₂ laser, can be used. In a case where a pulse width is shorter than 30 ns, the peak intensity of a laser pulse becomes too high, and thus a semiconductor material (silicon) or an implanted dopant is ablated or evaporated, whereby a problem such as a change in composition may occur. In a case where a pulse width exceeds 250 ns, since energy density required to melt a silicon wafer to a desired depth becomes high, it is necessary to make a beam size (the size of an incidence area) small, and thus a throughput is reduced.

Fig. 5 is a graph showing energy density required to obtain a molten depth of 0.3 µm by irradiating a silicon wafer with the pulsed laser beam 10a that is the second harmonic of the Nd:YAG laser. The horizontal axis of the graph represents the pulse width of the pulsed laser beam 10a in a unit of "ns", and the vertical axis represents energy density required for melting to the position of a depth of 0.3 µm from the laser irradiated surface in a unit of "J/cm²".

In a case where the pulse width of the pulsed laser beam 10a is 30 ns, the energy density required to melt a portion of a depth of 0.3 µm from the laser irradiated surface is 1.8 J/cm². The energy density required to melt the position of a depth of 0.3 µm from the laser irradiated surface increases according to an increase in pulse width, and in a case where the pulse width is 250 ns, the energy density is 3.4 J/cm².

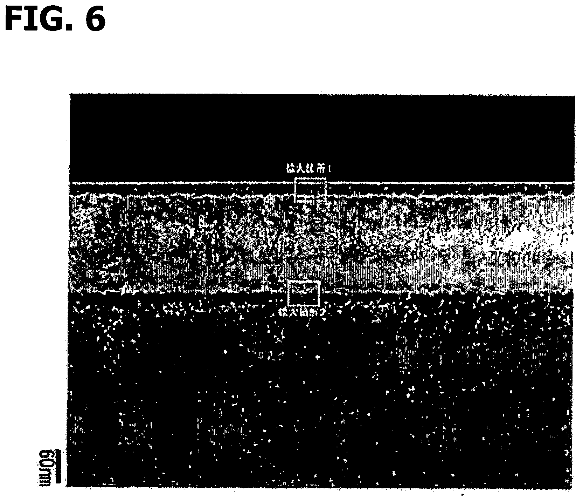

Fig. 6 is a cross-sectional TEM (transmission electron microscope) image of a silicon wafer with phosphorus (P) as dopants ion-implanted therein with energy of 100 keV and at a dose amount of 2E+15/cm². In the silicon wafer whose cross-sectional TEM image is shown in this drawing, unlike the silicon wafer 50 having the dopant depth profile shown in Fig. 2, phosphorus (P) as dopants is implanted into the relatively shallow area (an area having a depth of about 0.2 µm from the surface of the silicon wafer) at relatively high concentration. It can be seen that in a portion of the area with phosphorus (P) implanted therein, a crystal of silicon is amorphized. An amorphized area is whitely shown in the TEM image shown in this drawing.

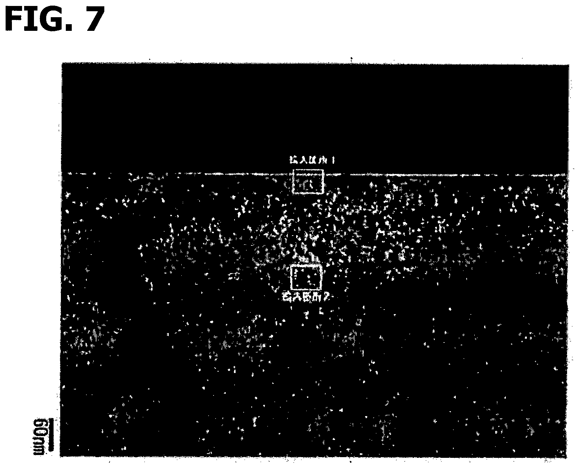

Fig. 7 is a cross-sectional TEM image of the silicon wafer after the silicon wafer shown in Fig. 6 is annealed by being irradiated with laser pulses having a relatively short pulse width. A surface layer portion of the silicon wafer was melted by irradiating the silicon wafer with the second harmonic of the Nd:YLF laser having a pulse width of 130 ns and pulse energy density of 1.6 J/cm² by two shots with a delay time of 500 ns provided. A state is confirmed where due to annealing, the crystallinity of the area that has been in an amorphous state is recovered to the extent that defects are not observed in the TEM image. It is thought that since an amorphous area and a layer including many defects are melted by the irradiation of a laser having a relatively short pulse width and crystals grow from a solid-liquid interface with no defect by epitaxial growth, a crystal structure in which defects are very few is obtained.

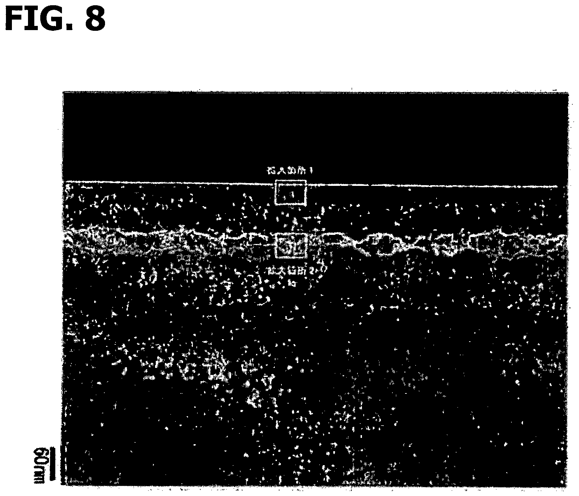

Fig. 8 is a cross-sectional TEM image of the silicon wafer after the silicon wafer shown in Fig. 6 is annealed by being irradiated with laser pulses having a relatively long pulse width. The silicon wafer was irradiated with a semiconductor laser (wavelength: 808 nm) under the condition (pulse width: 40 µs, power density: 300 kW/cm²) that the silicon wafer is not melt. In non-melting annealing by the irradiation of a laser having a relatively long pulse width, it is confirmed that crystals grow from the top and bottom of an amorphized area and a structure in which an amorphous state or crystal defects remain is formed.

From the TEM images shown in Figs. 6 to 8, it can be seen that the relatively shallow area with dopants added thereto at relatively high concentration recovers a good crystal structure due to melting annealing using laser pulses having a relatively short pulse width.

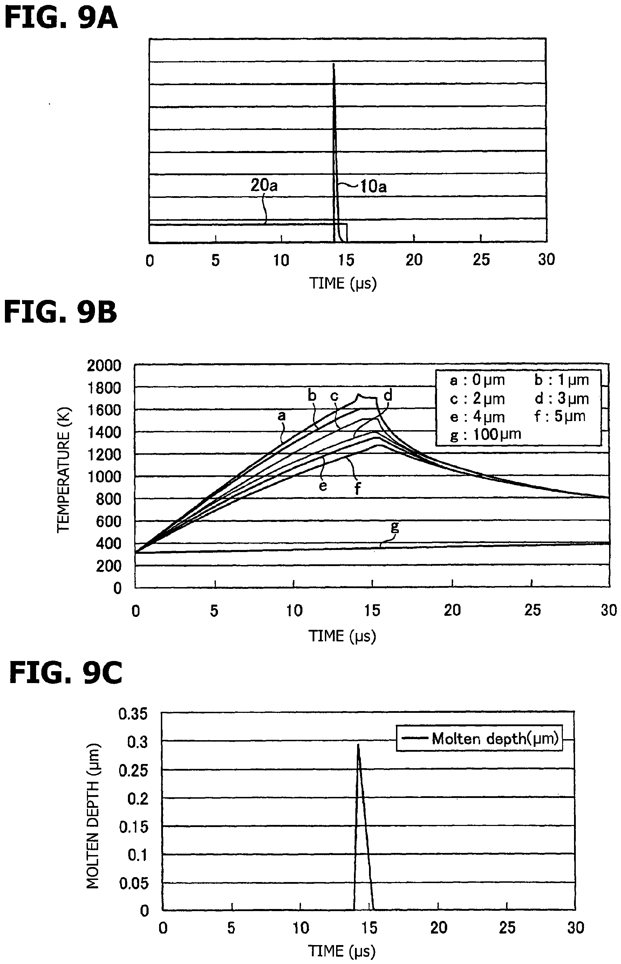

A laser annealing method according to a first example will be described referring to Figs. 9A to 9C. The laser annealing method according to the first example uses the laser anneal apparatus according to the example and can be carried out under the control of the control device 40.

First, the silicon wafer 50 is prepared in which dopants are added to a relatively deep area, for example, an area in which a depth exceeds 1 µm, of a surface layer portion of a laser irradiated surface at relatively low concentration and dopants are added to a relatively shallow area, for example, an area in which a depth is less than or equal to 1 µm, at relatively high concentration. The silicon wafer 50 that is used in the laser annealing method according to the first example is fabricated as follows. After phosphorus (P) as dopants is ion-implanted into a silicon wafer with energy of 700 keV and at a dose amount of 1E+14/cm², a resist is formed on the surface of the wafer, and boron (B) is ion-implanted into an area in which the resist is not formed, with energy of 20 keV and at a dose amount of 1E+15/cm². After removal of the resist, a resist is formed again and phosphorus is ion-implanted into areas other than the area with boron implanted therein, with energy of 50 keV and at a dose amount of 2E+15/cm². The phosphorus is added to the relatively deep area of a surface layer portion of the silicon wafer 50 at relatively low concentration and the boron is added to a relatively shallow area at relatively high concentration.

In a case where a silicon wafer in which ion implantation of phosphorus is performed on a relatively shallow area at relatively high concentration is to be an annealing target instead of the silicon wafer 50, silicon is amorphized at least in a portion of, for example, the area with phosphorus implanted therein.

Laser annealing is performed which activates the phosphorus and the boron added to the silicon wafer 50 by irradiating the same area on the silicon wafer 50 fabricated in this manner with the pulsed laser beam 10a (a pulsed laser beam having a relatively short pulse width) from the solid-state laser 10 and the pulsed laser beam 20a (a pulsed laser beam having a relatively long pulse width) from the semiconductor laser 20 with the pulsed laser beams overlapped on the same optical axis by the dichroic mirror 15.

The activation of high concentration dopants is performed by melting the silicon wafer 50 to a position deeper than the area with the high concentration dopants added thereto. Low concentration dopants are activated without melting the silicon wafer 50 to the area with the low concentration dopants added thereto.

Fig. 9A is a graph showing temporal waveforms of the light intensities of the pulsed laser beams 10a and 20a. The horizontal axis of the graph represents elapsed time based on the time of emission of the pulsed laser beam 20a in a unit of "µs". The vertical axis represents the light intensities of the pulsed laser beams 10a and 20a. In the laser annealing method according to the first example, the pulsed laser beam 20a having a pulse width of 15 µs is emitted from the semiconductor laser 20 and is incident on the silicon wafer 50 at power density of 400 kW/cm² with an attenuation rate adjusted by the attenuator 21. Further, at the point of time when 14 µs has elapsed after the start of the irradiation of the pulsed laser beam 20a to the silicon wafer 50, the pulsed laser beam 10a that is the second harmonic of the Nd:YLF laser having a pulse width of 150 ns is emitted from the solid-state laser 10 and is incident on the silicon wafer 50 at energy density of 0.7 J/cm² with an attenuation rate adjusted by the attenuator 11.

Fig. 9B is simulation results showing changes in the temperature of the silicon wafer 50. The horizontal axis of the graph represents elapsed time based on the time of emission of the pulsed laser beam 20a in a unit of "µs". The vertical axis represents the temperature of the silicon wafer 50 in a unit of "K". A curve a shows the surface temperature of the laser irradiated surface of the silicon wafer 50. Curves b to f respectively show changes in the temperature of positions where depths from the laser irradiated surface are 1 µm to 5 µm. A curve g shows a change in the temperature of a position (a laser non-irradiated surface of the silicon wafer 50 having a thickness of 100 µm) where a depth from the laser irradiated surface is 100 µm.

The silicon wafer 50 is irradiated with the pulsed laser beam 20a, whereby the wafer 50 is heated, and at 14 µs after the irradiation is started, the temperature of the laser irradiated surface reaches 1660K close to the melting point of silicon. However, at this point of time, the silicon has not been melted yet. The silicon wafer 50 in this state is irradiated with the pulsed laser beam 10a. Due to the irradiation of the pulsed laser beam 10a, the temperature of the silicon wafer 50 reaches the melting point of the silicon.

Fig. 9C is a graph showing a molten depth of the silicon wafer 50. The horizontal axis of the graph represents elapsed time based on the time of emission of the pulsed laser beam 20a in a unit of "µs", and the vertical axis represents a molten depth from the laser irradiated surface of the silicon wafer 50 in a unit of "µm". It can be seen that the silicon wafer 50 which has not been melted in the irradiation of the pulsed laser beam 20a is melted to a depth of about 0.3 µm from the laser irradiated surface by the irradiation of the pulsed laser beam 10a.

With a decrease in temperature of the silicon wafer 50, the melted silicon that includes the ion-implanted dopants (B) epitaxially grows, whereby the recovery of crystal defects and the activation of the dopants (B) are performed in the relatively shallow area.

On the other hand, the dopants (P) implanted into the relatively deep area, for example, the area in which a depth exceeds 1 µm, at relatively low concentration are heated in the state of a solid phase and activated being incorporated into the lattice locations of the silicon. From the temperature history shown by the curves b to f of, for example, Fig. 9B, it will be able to be said that the phosphorus implanted into the relatively deep area is activated by the energy of the pulsed laser beam 20a.

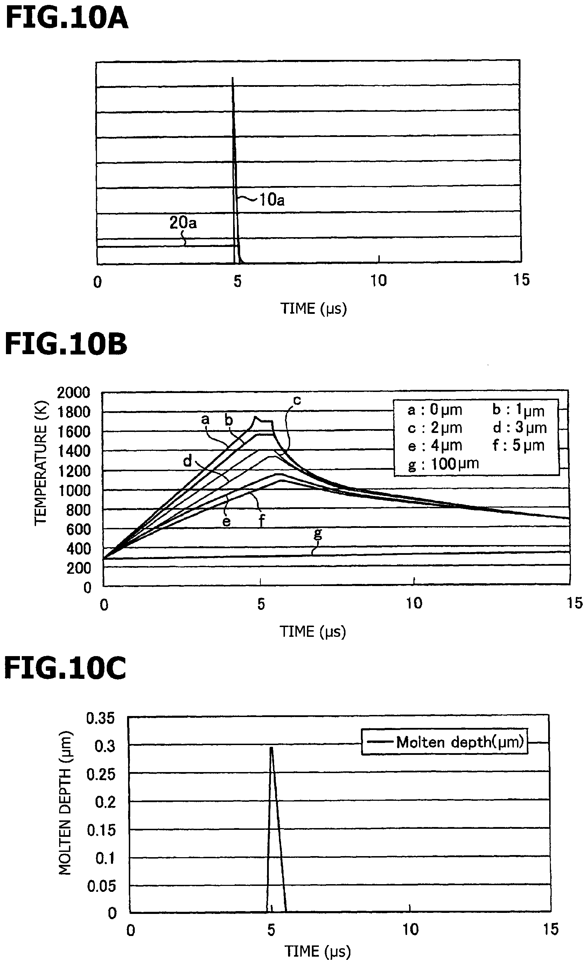

A laser annealing method according to a second example will be described referring to Figs. 10A to 10C. The laser annealing method according to the second example is different from the laser annealing method according to the first example in an addition aspect of dopants to the silicon wafer 50 and an irradiation aspect of the pulsed laser beams 10a and 20a to the silicon wafer 50.

The silicon wafer 50 that is used in the laser annealing method according to the second example is fabricated as follows. After phosphorus (P) as dopants is ion-implanted into a silicon wafer with energy of 700 keV and at a dose amount of 1E+14/cm², a resist is formed on the surface of the wafer, and boron (B) is ion-implanted into an area in which the resist is not formed, with energy of 40 keV and at a dose amount of 1E+15/cm². After removal of the resist, a resist is formed again and phosphorus is ion-implanted into areas other than the area with the boron implanted therein, with energy of 100 keV and at a dose amount of 2E+15/cm².

Also in a surface layer portion of the laser irradiated surface of the silicon wafer 50 that is to be an annealing target in the laser annealing method according to the second example, phosphorus is added to a relatively deep area at relatively low concentration and boron is added to a relatively shallow area at relatively high concentration.

Fig. 10A is a graph showing temporal waveforms of the light intensities of the pulsed laser beams 10a and 20a in the second example. The meanings of the horizontal axis and the vertical axis of the graph are equal to those in Fig. 9A. In the laser annealing method according to the second example, the pulsed laser beam 20a having a pulse width of 5 µs is emitted from the semiconductor laser 20 and is incident on the silicon wafer 50 at power density of 700 kW/cm² with an attenuation rate adjusted by the attenuator 21. Further, at the point of time when 4.8 µs has elapsed after the start of the irradiation of the pulsed laser beam 20a to the silicon wafer 50, the pulsed laser beam 10a that is the fundamental wave (wavelength: 1064 nm) of the Nd:YAG laser having a pulse width of 80 ns is emitted from the solid-state laser 10 and is incident on the silicon wafer 50 at energy density of 0.7 J/cm² with an attenuation rate adjusted by the attenuator 11.

Fig. 10B is simulation results showing changes in the temperature of the silicon wafer 50. The meanings of both the axes and curves a to g of the graph are equal to those in Fig. 9B.

The silicon wafer 50 is irradiated with the pulsed laser beam 20a, whereby the wafer 50 is heated, and at 4.8 µs after the irradiation is started, the surface temperature of the laser irradiated surface reaches the vicinity of the melting point of silicon. However, the silicon has not been melted. The pulsed laser beam 10a is incident on the silicon wafer 50 in this state. Due to the irradiation of the pulsed laser beam 10a, the temperature of the silicon wafer 50 reaches the melting point of the silicon.

Fig. 10C is a graph showing a molten depth of the silicon wafer 50. The meanings of both the axes of the graph are equal to those in Fig. 9C. The silicon wafer 50 which has not been melted in the irradiation of the pulsed laser beam 20a is melted to a depth of about 0.3 µm from the laser irradiated surface by the irradiation of the pulsed laser beam 10a.

The temperature of the silicon wafer 50 is lowered. The melted silicon that includes the ion-implanted dopants (B) epitaxially grows, whereby the recovery of crystal defects and the activation of the dopants (B) are performed in the relatively shallow area.

Further, the dopants (P) added to the relatively deep area, for example, the area in which a depth exceeds 1 µm, at relatively low concentration are heated in the state of a solid phase and activated being incorporated into the lattice locations of the silicon.

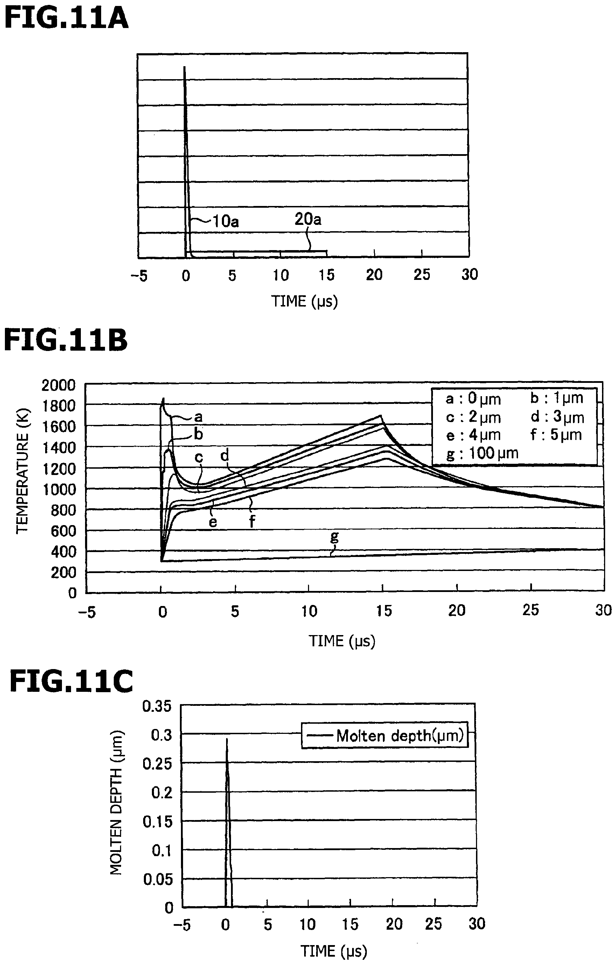

A laser annealing method according to a third example will be described referring to Figs. 11A to 11C. The laser annealing method according to the third example is different from the laser annealing method according to the first example in an irradiation aspect of the pulsed laser beams 10a and 20a to the silicon wafer 50. An addition aspect of dopants to the silicon wafer 50 is equal to that in the first example.

Fig. 11A is a graph showing temporal waveforms of the light intensities of the pulsed laser beams 10a and 20a in the third example. The meanings of the horizontal axis and the vertical axis of the graph are equal to those in Fig. 9A. In the laser annealing method according to the third example, emission of the pulsed laser beam 20a from the semiconductor laser 20 and emission of the pulsed laser beam 10a from the solid-state laser 10 are performed continuously.

The pulsed laser beam 20a having a pulse width of 15 µs is emitted from the semiconductor laser 20 and is incident on the silicon wafer 50 at power density of 340 kW/cm² with an attenuation rate adjusted by the attenuator 21. Further, the pulsed laser beam 10a that is the second harmonic of the Nd:YLF laser having a pulse width of 150 ns is emitted from the solid-state laser 10 and is incident on the silicon wafer 50 at energy density of 2.7 J/cm² with an attenuation rate adjusted by the attenuator 11.

Fig. 11B is simulation results showing changes in the temperature of the silicon wafer 50. The meanings of both the axes and curves a to g of the graph are equal to those in Fig. 9B. The surface temperature of the silicon wafer 50 reaches the melting point of silicon by the irradiation of the pulsed laser beam 10a. After the end of incidence of the pulsed laser beam 10a, the temperature of the vicinity of the laser irradiated surface is lowered first. The temperature of the silicon wafer 50 rises due to the irradiation of the pulsed laser beam 20a.

Fig. 11C is a graph showing a molten depth of the silicon wafer 50. The meanings of both the axes of the graph are equal to those in Fig. 9C. The silicon wafer 50 is melted to a depth of about 0.3 µm from the laser irradiated surface by the irradiation of the pulsed laser beam 10a.

The temperature of the silicon wafer 50 melted by the irradiation of the pulsed laser beam 10a is lowered and the melted silicon that includes the ion-implanted dopants (B) epitaxially grows, whereby the recovery of crystal defects and the activation of the dopants (B) are performed in the relatively shallow area.

The dopants (P) added to the relatively deep area, for example, the area in which a depth exceeds 1 µm, at relatively low concentration are heated in the state of a solid phase by the irradiation of the pulsed laser beam 20a having a pulse width of 15 µs and activated being incorporated into the lattice locations of the silicon.

By the laser annealing method according to the third example, it is possible to obtain the annealing effect equivalent to that of the laser annealing method according to the first example. However, in the laser annealing method according to the first example, the silicon wafer 50 is melted (a high concentration implantation layer is melted) to a depth of about 0.3 µm by the irradiation of the pulsed laser beam 10a in a state where the surface has reached a temperature close to the melting point of silicon by the irradiation of the pulsed laser beam 20a, whereas in the third example, in order to melt the silicon wafer 50 to a depth of about 0.3 µm by irradiating the silicon wafer 50 at normal temperature with the pulsed laser beam 10a, high energy density, for example, energy density of about four times is required for the pulsed laser beam 10a. For this reason, in order to carry out the laser processing method according to the third example, a high-power light source is prepared as the laser light source 10 or it is necessary to increase the energy density of the pulsed laser beam 10a which is incident on the silicon wafer 50 by making a beam size (the size of an incidence area) small, and thus there is a possibility that a problem of an increase in cost or a decrease in throughput may be caused. Therefore, it will be possible to more preferably perform laser annealing by using the first example. It is possible to reduce the energy density of the pulsed laser beam 10a by melting the surface by making the pulsed laser beam 10a having a relatively short pulse width incident thereon in a state where the silicon wafer 50 is heated until the surface temperature reaches the vicinity of the melting point of the silicon by the irradiation of the pulsed laser beam 20a having a relatively long pulse width.

In the first and second examples, the pulsed laser beam 10a having a relatively short pulse width is incident on the silicon wafer 50 just before the end of the irradiation of the pulsed laser beam 20a having a relatively long pulse width. However, energy efficiency will be the highest when making the pulsed laser beam 10a incident on the silicon wafer 50 just after the end of the irradiation of the pulsed laser beam 20a. However, as in the laser annealing methods according to the first to third examples, the irradiation periods of both the pulsed laser beams 10a and 20a may partially overlap. Further, it is also possible to provide an interval between the irradiation periods of both the pulsed laser beams 10a and 20a.

By the laser annealing method according the example, it is possible to perform high-quality laser annealing.

The inventors of the present application performed laser annealing by irradiating the silicon wafer 50 fabricated by adding dopants thereto in the same aspect as those in the first and third examples with the pulsed laser beam 20a having a pulse width of 40 µs and power density of 300 kW/cm², as a laser annealing method according to a comparative example. In the silicon wafer 50 after the annealing, a sheet resistance value was reduced and the activation of the implanted dopants was confirmed. However, when a cross section of the wafer was observed, a large number of crystal defects remained.

The invention has been described above according to the examples. However, the invention is not limited to the examples.

For instance, in an example, the silicon wafer 50 in which phosphorus is added to the relatively deep area at relatively low concentration and boron is added to the relatively shallow area at relatively high concentration was an annealing target. However, the dopants that are added are not limited thereto. For example, a semiconductor substrate in which phosphorus is added to both the relatively deep area and the relatively shallow area at relatively low concentration in the relatively deep area and at relatively high concentration in the relatively shallow area may be an annealing target. As described previously, in such a semiconductor substrate, amorphization occurs in the semiconductor substrate at least at a portion of, for example, the relatively shallow area with phosphorus implanted therein. By the laser annealing method according to the example, the relatively shallow area that includes an area in which, for instance, silicon is amorphized is melted by the irradiation of laser pulses having a relatively short pulse width and sufficient dopant (P) activation is performed by liquid phase epitaxial growth in a process in which crystal defects are recovered. In the relatively deep area, laser pulses having a relatively long pulse width are incident and sufficient activation of dopants (P) is performed by non-melting annealing.

In this manner, in an amorphized area and an area in which crystal defects are present, melting annealing is performed and good crystallinity is realized. In an area that is not amorphized and an area in which there is no crystal defect, non-melting annealing (solid phase annealing) is performed. In laser annealing of a silicon wafer that is used for the production of, for instance, the IGBT, since it is not preferable that a front-side surface layer portion be subjected to high temperature, non-melting annealing is suitable also in terms of being capable of contributing to the realization of good device characteristics.

It will be apparent to those skilled in the art that various modifications, improvements, combinations, or the like can be made within the scope of the present invention as defined by the appended claims.

### Industrial Applicability

The invention can be used for the production of, for example, a semiconductor device, or an IGBT as an example.

## Claims

1. A laser annealing method comprising:
(a) preparing a semiconductor substrate (50) in which dopants are added to a relatively deep area of a surface layer portion at relatively low concentration and dopants are added to a relatively shallow area at relatively high concentration; and
(b) irradiating the semiconductor substrate with a laser beam so that high concentration dopants added to the relatively shallow area are activated by melting the semiconductor substrate to a position deeper than the area with the high concentration dopants added thereto and low concentration dopants added to the relatively deep area are activated without melting the semiconductor substrate to the area with the low concentration dopants added thereto,
wherein:
in the irradiating step (b), the dopants added to the relatively shallow area are activated by irradiating the semiconductor substrate with a first pulsed laser beam (10a) having a relatively short pulse width to melt the semiconductor substrate at an irradiated position, and the dopants added to the relatively deep area are activated by irradiating the semiconductor substrate with a second pulsed laser beam (20a) having a relatively long pulse width which is greater than or equal to 20 times the pulse width of the first pulsed laser beam,
in the irradiating step (b), the dopants added to the relatively shallow area are activated by irradiating the semiconductor substrate with the first pulsed laser beam to melt the semiconductor substrate at the irradiated position, in a state where the semiconductor substrate is heated, by irradiating the semiconductor substrate with the second pulsed laser beam, to a temperature at which the semiconductor substrate does not melt;
a fundamental wave or a second harmonic of a Q-switched solid-state laser is used as the first pulsed laser beam, and
a semiconductor laser having a wave length longer than or equal to 808 nm and less than or equal to 950 nm is used as the second pulsed laser beam.

2. The laser annealing method according to Claim 1,
wherein in the semiconductor substrate that is prepared in the preparing step (a), at least a portion of the area with the dopants added thereto at relatively high concentration is amorphized.

3. A laser annealing apparatus comprising:
a first laser light source (10) that emits a first pulsed laser beam having a relatively short pulse width, the first laser light source being a Q-switched solid-state laser emitting a fundamental wave or a second harmonic;
a second laser light source (20) that emits a second pulsed laser beam having a relatively long pulse width which is greater than or equal to 20 times the pulse width of the first pulsed laser beam, the second light source being a semiconductor laser having a wave length longer than or equal to 808 nm and less than or equal to 950 nm;
a stage (30) that retains a semiconductor substrate in which dopants are added to a relatively deep area of a surface layer portion at relatively low concentration and dopants are added to a relatively shallow area at relatively high concentration;
a propagation optical system adapted to propagate the first pulsed laser beam emitted from the first laser light source and the second pulsed laser beam emitted from the second laser light source to the same area on the semiconductor substrate retained on the stage, which includes a beam overlapper that overlaps the first pulsed laser beam and the second pulsed laser beam on a same optical axis, and is adapted to propagate the first pulsed laser beam at energy density that melts the semiconductor substrate to a position deeper than the area with the high concentration dopants added thereto, and to propagate the second pulsed laser beam at energy density that does not melt the semiconductor substrate to the area with the low concentration dopants added thereto, and.
a control device (40) that is adapted to control emission of the first pulsed laser beam from the first laser light source and emission of the second pulsed laser beam from the second laser light source in such a manner that the semiconductor substrate is irradiated with the first pulsed laser beam to melt the semiconductor substrate at an irradiated position, in a state where the semiconductor substrate is heated, by irradiating the semiconductor substrate with the second pulsed laser beam, to a temperature at which the semiconductor substrate does not melt.

## Patentansprüche

1. Laserwärmebehandlungsverfahren, das Folgendes aufweist:
(a) Vorbereiten eines Halbleitersubstrats (50), in dem Dotierungsmittel bzw. Dotierstoffe zu einem relativ tiefen Bereich eines Oberflächenschichtteils mit relativ niedriger Konzentration hinzugefügt sind und Dotierstoffe zu einem relativ flachen Bereich mit relativ hoher Konzentration hinzugefügt sind;
(b) Bestrahlen des Halbleitersubstrat mit einem Laserstrahl, so dass Hochkonzentrationsdotierstoffe, die zu dem relativ flachen Bereich hinzugefügt sind, durch Schmelzen des Halbleitersubstrats zu einer Position, die tiefer als der Bereich mit den dazu hinzugefügten Hochkonzentrationsdotierstoffen ist, aktiviert werden und die Schwachkonzentrationsdotierstoffe, die zu dem relativ tieferen Bereich hinzugefügt wurden, ohne Schmelzen des Halbleitersubstrats bis zu dem Bereich mit den dazu hinzugefügten Schwachkonzentrationsdotierstoffen, aktiviert werden,
wobei:
in dem Bestrahlungsschritt (b) die Dotierstoffe, die zu dem relativ flachen Bereich hinzugefügt wurden, durch Bestrahlen des Halbleitersubstrats mit einem ersten pulsierten Laserstrahl (10a) mit einer relativ kurzen Impulsdauer aktiviert werden, um das Halbleitersubstrat bei einer Bestrahlungsposition zu schmelzen, und die Dotierstoffe, die zu dem relativ tiefen Bereich hinzugefügt wurden, durch Bestrahlen des Halbleitersubstrats mit einem zweiten pulsierten Laserstrahl (10) mit einer relativ langen Impulsdauer aktiviert werden, die größer oder gleich dem 20-fachen der Impulsdauer des ersten pulsierten Laserstrahl ist,
in dem Bestrahlungsschritt (b) die Dotierstoffe, die zu dem relativ flachen Bereich hinzugefügt wurden, durch Bestrahlen des Halbleitersubstrats mit dem ersten pulsierten Laserstrahl aktiviert werden, um das Halbleitersubstrat bei der Bestrahlungsposition in einem Zustand zu schmelzen, wo das Halbleitersubstrat durch Bestrahlen des Halbleitersubstrats mit dem zweiten pulsierten Laserstrahl erwärmt wird, und zwar bis zu einer Temperatur bei der das Halbleitersubstrat nicht schmilzt;
eine Grundwelle oder eine zweite Harmonische eines mit Güteschalter versehenen Festkörper- bzw. Halbleiterlasers bzw. eines Q-Switch-Halbleiterlasers als der erste pulsierte Laserstrahl verwendet wird, und
ein Halbleiterlaser mit einer Wellenlänge von 808nm oder länger und kleiner oder gleich 950nm als zweiter pulsierter Laserstrahl verwendet wird.

2. Laserwärmebehandlungsverfahren gemäß Anspruch 1, wobei in dem Halbleitersubstrat, das in dem Vorbereitungsschritt (a) vorbereitet wird, zumindest ein Teil des Bereichs zu dem die Dotierstoffe mit relativ hoher Konzentration hinzugefügt sind, amorph gemacht wird.

3. Laserwärmebehandlungsvorrichtung, die Folgendes aufweist:
eine erste Laserlichtquelle (10), die einen ersten pulsierten Laserstrahl mit einer relativ kurzen Impulsdauer emittiert, wobei die erste Laserlichtquelle ein mit Güteschalter versehender Festkörperlaser bzw. ein Q-Switch-Halbleiterlaser ist, der eine Grundwelle oder eine zweite Harmonische emittiert;
eine zweite Laserlichtquelle (20), die einen zweiten pulsierten Laserstrahl mit einer relativ langen Impulsdauer emittiert, die größer oder gleich dem 20-fachen der Impulsdauer des ersten pulsierten Laserstrahls ist, wobei die zweite Lichtquelle ein Halbleiterlaser mit einer Wellenlänge ist, die 808nm entspricht oder länger ist und kleiner oder gleich 950nm ist;
ein Objekttisch (30), der ein Halbleitersubstrat hält, in dem Dotierstoffe zu einem relativ tiefen Bereich eines Oberflächenschichtteils mit relativ geringer Konzentration hinzugefügt sind und Dotierstoffe zu einem relativ flachen Bereich mit relativ hoher Konzentration hinzugefügt sind;
ein System zur optischen Ausbreitung, das ausgelegt ist um den ersten pulsierten Laserstrahl, der von der ersten Laserlichtquelle emittiert wird, und den zweiten pulsierten Laserstrahl, der von der zweiten Laserlichtquelle emittiert wird, zu dem gleichen Bereich des Halbleitersubstrats, das auf dem Objekttisch gehalten wird, auszubreiten, welches eine Strahlüberlappungsvorrichtung aufweist, die den ersten pulsierten Laserstrahl und den zweiten pulsierten Laserstrahl auf einer gleichen optischen Achse überlappt, und ausgelegt ist, um den ersten pulsierten Laserstrahl mit einer Energiedichte auszubreiten, die das Halbleitersubstrat zu einer Position abschmilzt, die tiefer als der Bereich mit den dazu hinzugefügten Hochkonzentrationsdotierstoffen ist, und um den zweiten Laserstrahl mit einer Energiedichte auszubreiten, die das Halbleitersubstrat nicht bis zu dem Bereich mit den dazu hinzugefügten Schwachkonzentrationsdotierstoffen abschmilzt, und
eine Steuervorrichtung (40), die ausgelegt ist, um die Emission des ersten pulsierten Laserstrahls von der ersten Laserlichtquelle und die Emission des zweiten pulsierten Laserstrahls von der zweiten Laserlichtquelle in einer solchen Art und Weise zu steuern, dass das Halbleitersubstrat mit dem ersten pulsierten Laserstrahl bestrahlt wird, um das Halbleitersubstrat bei einer Bestrahlungsposition in einem Zustand zu schmelzen, in dem das Halbleitersubstrat durch Bestrahlen des Halbleitersubstrats mit dem zweiten pulsierten Laserstrahl auf eine Temperatur erwärmt wird, bei der das Halbleitersubstrat nicht schmilzt.

## Revendications

1. Procédé de recuit au laser comprenant :
(a) préparer un substrat semi-conducteur (50) dans lequel des dopants sont ajoutés à une région relativement profonde d'une portion d'une couche de surface avec une concentration relativement faible et des dopants sont ajoutés à une région relativement peu profonde avec une concentration relativement élevée ; et
(b) irradier le substrat semi-conducteur avec un faisceau laser de telle sorte que des dopants à concentration élevée ajoutés à la région relativement peu profonde sont activés en faisant fondre le substrat semi-conducteur jusqu'à une position plus profonde que la région ayant les dopants ajoutés à concentration élevée, et des dopants à faible concentration ajoutés à la région relativement profonde sont activés sans faire fondre le substrat semi-conducteur jusqu'à la région ayant les dopants ajoutés à faible concentration,
dans lequel :
dans l'étape d'irradiation (b), les dopants ajoutés à la région relativement peu profonde sont activés en irradiant le substrat semi-conducteur avec un premier faisceau laser pulsé (10a) ayant une largeur d'impulsion relativement courte pour faire fondre le substrat semi-conducteur à une position irradiée, et les dopants ajoutés à la région relativement profonde sont activés en irradiant le substrat semi-conducteur avec un deuxième faisceau laser pulsé (20a) ayant une largeur d'impulsion relativement longue qui est supérieure ou égale à 20 fois la largeur d'impulsion du premier faisceau laser pulsé,
dans l'étape d'irradiation (b), les dopants ajoutés à la région relativement peu profonde sont activés en irradiant le substrat semi-conducteur avec le premier faisceau laser pulsé pour faire fondre le substrat semi-conducteur au niveau de la position irradiée, dans un état où le substrat semi-conducteur est chauffé, en irradiant le substrat semi-conducteur avec le deuxième faisceau laser pulsé, jusqu'à une température à laquelle le substrat semi-conducteur ne fond pas ;
une onde fondamentale ou un deuxième harmonique d'un laser à état solide à commutation Q est utilisé comme premier faisceau laser pulsé, et
un laser semi-conducteur ayant une longueur d'onde supérieure ou égale à 808 nm et inférieure ou égale à 950 nm est utilisé comme deuxième faisceau laser pulsé.

2. Procédé de recuit au laser selon la revendication 1, dans lequel dans le substrat semi-conducteur qui est préparé dans l'étape de préparation (a), au moins une portion de la région ayant les dopants ajoutés avec une concentration relativement élevée est rendue amorphe.

3. Dispositif de recuit au laser comprenant :
une première source de lumière laser (10) qui émet un premier faisceau laser pulsé ayant une largeur d'impulsion relativement courte, la première source de lumière laser étant un laser à état solide à commutation Q émettant une onde fondamentale ou un deuxième harmonique ;
une deuxième source de lumière laser (20) qui émet un deuxième faisceau laser pulsé ayant une largeur d'impulsion relativement longue qui est supérieure ou égale à 20 fois la largeur d'impulsion du premier faisceau laser pulsé, la deuxième source de lumière étant un laser semi-conducteur ayant une longueur d'onde supérieure ou égale à 808 nm et inférieure ou égale à 950 nm ;
une étagère (30) qui retient un substrat semi-conducteur dans lequel des dopants sont ajoutés à une région relativement profonde d'une portion de couche de surface avec une concentration relativement faible et des dopants sont ajoutés à une région relativement peu profonde avec une concentration relativement élevée ;
un système optique de propagation adapté à propager le premier faisceau laser pulsé émis par la première source de lumière laser et le deuxième faisceau laser pulsé émis par la deuxième source de lumière laser vers la même région sur le substrat semi-conducteur maintenu sur l'étagère, qui comprend un dispositif de superposition de faisceaux qui superpose le premier faisceau laser pulsé et le deuxième faisceau laser pulsé sur un même axe optique, et est adapté à propager le premier faisceau laser pulsé avec une densité d'énergie qui fait fondre le substrat semi-conducteur jusqu'à une position plus profonde que la région ayant les dopants ajoutés à concentration élevée, et à propager le deuxième faisceau laser pulsé avec une densité d'énergie qui ne fait pas fondre le substrat semi-conducteur jusqu'à la région ayant les dopants ajoutés à faible concentration, et
un dispositif de commande (40) qui est adapté à contrôler l'émission du premier faisceau laser pulsé à partir de la première source de lumière laser et l'émission du deuxième faisceau laser pulsé à partir de la deuxième source de lumière laser de telle sorte que le substrat semi-conducteur est irradié avec le premier faisceau laser pulsé pour faire fondre le substrat semi-conducteur à une position irradiée, dans un état où le substrat semi-conducteur est chauffé, en irradiant le substrat semi-conducteur avec le deuxième faisceau laser pulsé, jusqu'à une température à laquelle le substrat semi-conducteur ne fond pas.
